# EUROPEAN PATENT SPECIFICATION

(11) **EP 1 612 851 B1**
(45) Date of publication and mention of the grant of the patent: **03.03.2010**
(21) Application number: 04076897.0
(22) Date of filing: 30.06.2004
(51) Int. Cl.: H01L 21/04, H01L 29/24

(54) **A method for the treatment of a surface of a metal-carbide substrate for use in semiconductor manufacturing processes as well as such a metal-carbide substrate**
Verfahren zur Oberflächenbehandlung eines Metallcarbid-Substrates zur Verwendung in Halbleiterherstellungverfahren und ein Metallcarbid-Substrat an sich
Procédé de traitement d'une surface d'un substrat de carbure métallique pour son utilisation dans un procédé de fabrication de semiconducteurs et un carbure métallique

(43) Date of publication of application: 04.01.2006
(73) Proprietor: Xycarb Ceramics B.V., 5705 CS Helmond (NL)
(72) Inventor: Van Munster, Marcus Gerardus, 5038SC Tilburg (NL)
(74) Representative: Valkonet, Rutger

(56) References cited:
- WO-A-01/45148
- WO-A-02/086180
- US-A1- 2002 033 130
- JEON I D ET AL: "Formation of carbon coatings on silicon carbide by reactions in halogen containing media" PROCEEDINGS OF THE SYMPOSIUM ON FUNDAMENTAL ASPECTS OF HIGH TEMPERATURES, XX, XX, vol. 96-26, 1997, pages 256-268, XP008007082
- ERSOY D A ET AL: "High temperature chlorination of SiC for preparation of tribological carbon films" PROCEEDINGS OF THE SYMPOSIUM ON HIGH TEMPERATURE CORROSION AND MATERIALS CHEMISTRY, XX, XX, 1998, pages 324-333, XP000981692
- GOGOTSI Y G ET AL: "CARBON COATINS ON SILICON CARBIDE BY REACTION WITH CHLORINE-CONTAINING GASES" JOURNAL OF MATERIALS CHEMISTRY, THE ROYAL SOCIETY OF CHEMISTRY, CAMBRIDGE, GB, vol. 7, no. 9, 1 September 1997 (1997-09-01), pages 1841-1848, XP000724179 ISSN: 0959-9428

## Description

### FIELD OF THE INVENTION

The invention relates to a method for the treatment of a surface of a metal-carbide substrate, said metal-carbide substrate being used in semiconductor manufacturing processes.

The invention also relates to a metal-carbide substrate for use in semiconductor manufacturing processes treated with to the method according to the invention.

### BACKGROUND OF THE INVENTION

Metal-carbide substrates, such as silicon-carbide SiC, are known for their use in semiconductor manufacturing processes. More in particularly metal-carbide is used as starting material from which for example wafer boats or support rings are constructed. Such constructions serve as a holder and positioning means for multiple wafers, which wafers are subjected to several treatment steps during semiconductor fabrication. Such treatment process steps are performed under specific, well controlled conditions as regards to temperature, pressure and vacuum and can be the deposition of several semiconductor material layers on said wafers, for example using chemical vapour deposition techniques (CVD) or other process steps such as temperature annealing.

It should be noted in this patent application with the term "metal-carbide substrates" not only wafer boat holders are meant, but also other constructions or components made from a metal-carbide material, which are used in semiconductor manufacturing processes, for example in reactor vessels.

In US2002/033130 a SiC substrate is disclosed of which the surface has been etched. After said ething step a SiC substrate laver consisting of Si and C atoms remains, This surface is exposed to oxygen gas and Si and C atoms are removed as SiO gas, CO gas and O₂ gas. After this treatment a substrate having a surface of SiC which is not contaminated wit Si or C is obtained. WO 2002/086180 discloses a process for the synthesis of carbon coatings on the surface of metal carbides by etching in a halogen-containing gaseous etchant. In WO 2001/45148 a method for the production of high quality thermally grown oxide on SiC is described, said method including etching techniques by selectively remove carbon from amorphized silicon carbide. In JEON I.D. et.al. "Formation of carbon coatings on silicon carbide by reactions in halogen containing media" Proceedings of the symposium on fundamental aspects of high temperatures, XX, XX, vol. 96-26, 1997, pages 256-268, in ERSOY D.A. et.al. "High temperature chlorination of SiC for preparation of tribological carbon films" Proceedings of the symposium on high temperature corrosion and materials chemistry, XX, XX, 1998, pages 324-333, and in GOGOTSI Y.G. et.al. "Carbon coatins on silicon carbide by reaction with chlorine-containing gases" Journal of materials chemistry the formation of carbon coatings on SiC by means of halogen containing etching media under various conditions and on various SiC substrates is dosclosed.

As the subsequent treatment process steps of the semiconductor manufacturing processes (such as semiconductor layer deposition) takes place under accurately controlled circumstances as regard as temperature, pressure and vacuum and also require so-called clean room environments needs to fulfill the highest standard as regard to purity and lack of contaminations, also the metal-carbide substrates need to fulfill to the highest standard as regard to dimensions and thermal behaviour.

To this end the several metal-carbide substrate components which form for example a wafer boat holder are subjected to a mechanical machining operation in order to treat the substrate surface. However the surface treatment by means of a mechanical machining operation results in stall nearly invisible micro cracks or holes in the surface of the metal-carbide substrates. These micro cracks or subsurface damage adversely affects the different subsequent semiconductor manufacturing processes (e.g. the semiconductor layer deposition or high temperature anneal) as all kinds of contaminations may accumulate in said micro cracks, which contaminations can be freed from said micro cracks during the semiconductor process thereby contaminate the semiconductor layer deposition on the wafers. The latter will result in significantly reduced quality or rejection of products.

A further drawback of the presence of subsurface damage on the metal-carbide substrate is the risk of particle generation and emission during the semiconductor manufacturing processes. Due to the changing thermal conditions during the several semiconductor layer depositions small metal-carbide particles will come loose from the metal-carbide substrate and hence contaminate the semiconductor manufacturing process.

It is an object of the invention to provide a method and a metal-carbide substrate as mentioned above which obviates the above-identified drawbacks.

According to the invention said method comprising the steps of selective etching the surface of said metal-carbide substrate using a reactive gas mixture thereby creating a carbon surface layer on said metal-carbide substrate, and removing said carbon surface layer being created on said metal-carbide substrate.

Thus with the method steps according to the invention metal-carbide substrates can be obtained with a surface structure that complies with the highest standards as regard to dimensions and purity as required in semiconductor manufacturing processes. Especially metal-carbide substrates treated according to the steps of the invention are highly suitable for use as wafer boats for handling and containing semiconductor wafers on which subsequent treatment process steps of the semiconductor manufacturing processes (such as semiconductor layer deposition or temperature annealing) are performed under accurate, well controlled working conditions (temperature, pressure and vacuum).

As all subsurface damage in the form of microcracks is removed with the removal of the carbon surface layer as smooth and clean SiC-surface is obtained having a extremely high purity as also all impurities are removed. Furthermore due to the removal of the subsurface damaged surface the generation and emission of particles from the metal-carbide surface, which particles may adversely affect the semiconductor manufacturing process, is herewith avoided.

Hence with a metal-carbide substrate treated with the method according to the invention a higher degree of purity can be obtained during semiconductor manufacturing processes with a higher level of accuracy and lesser rejection of products.

In a specific embodiment of the method according the invention is the step of removing said carbon surface layer performed by means of an oxidation treatment technique.

In another embodiment of the method according to the invention is the step of removing said carbon surface layer performed by means of a hydrogenation treatment technique. In another embodiment the step of removing said carbon surface layer is performed by means of a hydrothermical treatment technique.

Moreover in an advantageous embodiment of the invention a functional etching technique the reactive gas mixture being used during the step of etching the surface of said metal-carbide substrate is a halogen-containing gas mixture, wherein the halogen-containing gas concentration of said reactive gas mixture can be 100 %.

In another embodiment according to the invention the halogen-containing gas is chlorine (Cl₂) for example in an Argon-environment.

Furthermore in another advantageous embodiment with an excellent etching performance the reactive gas mixture also contains hydrogen (H₂).

In an example the flow rate of said reactive gas mixture is 0,5 - 5 litres per minute, whereas the working pressure of said reactive gas mixture may lie between 100 mbar and the ambient pressure and wherein the working temperature of said reactive gas mixture may lie between 1000°C and 1200°C.

The metal-carbide substrate for use in semiconductor manufacturing processes, is according to the invention characterized in that said metal-carbide substrate comprising a surface, wherein on said surface a carbon surface layer is formed by means of an etching technique using a reactive gas mixture, which carbon surface layer is subsequently being removed from said metal-carbide substrate.

Likewise is in an specific embodiment of the metal-carbide substrate according to the invention said carbon surface layer removed by means of an oxidation treatment technique. Or said carbon surface layer can be removed by means of a hydrogenation treatment technique. Likewise said carbon surface layer can be removed by means of a hydrothermical treatment technique.

In a specific embodiment of the metal-carbide substrate according to the invention said metal-carbide substrate surface is subjected to a reactive gas mixture consisting of a reactive gas mixture containing a halogen-containing gas mixture.

Furthermore in a more specific embodiment said halogen-containing gas concentration of said reactive gas mixture is 100 % and more in particular said halogen-containing gas is chlorine (Cl₂) in an Ar-environment. Furthermore the reactive gas mixture may also contain hydrogen (H₂).

Likewise the flow rate of said reactive gas mixture may lie 0,5 - 5 litres per minute, whereas said metal-carbide substrate surface may be subjected to a working pressure of said reactive gas mixture between 100 mbar and the ambient pressure or whereas said metal-carbide substrate surface is subjected to a working temperature of said reactive gas mixture between 1000 °C and 1200 °C.

### BRIEF DESCRIPTION OF THE DRAWINGS

The invention shall now be described by means of a drawing, which drawing shows in:

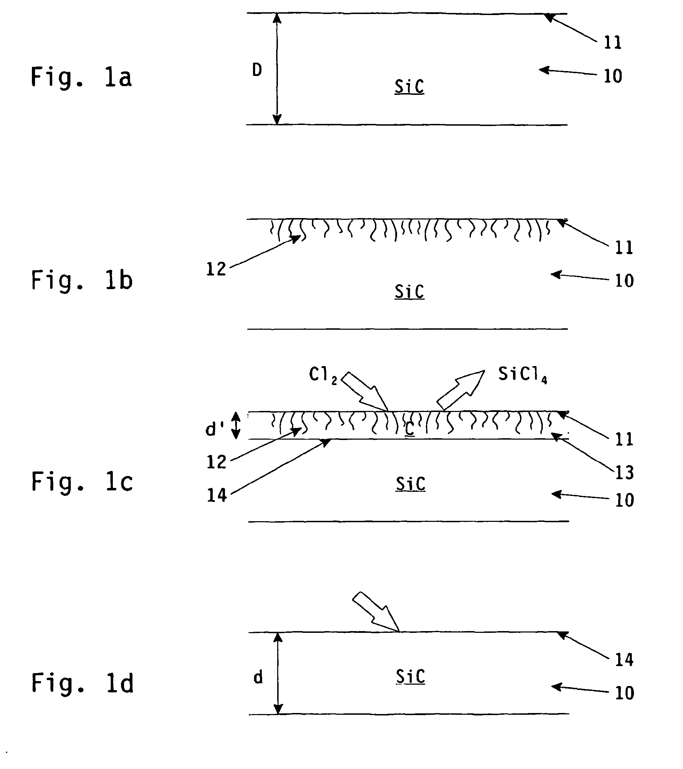

Figure 1a-1d an embodiment of a metal-carbide substrate according to the invention, when subjected or treated with the method according to the invention.

### DETAILED DESCRIPTION OF THE PREFERRED EMBODIMENTS

In Figure 1a a metal-carbide substrate 10 is disclosed with thickness D, for example silicon-carbide SiC, which substrate 10 is frequently used in semiconductor manufacturing processes. Metal-carbide is used as starting material from which for example wafer boats or support rings are constructed. Such constructions serve as a holder and positioning means for multiple wafers, which wafers are subjected to several treatment steps during semiconductor fabrication. Such treatment process steps are performed under specific, well controlled conditions as regards to temperature, pressure and vacuum and can be the deposition of several semiconductor material layers on said wafers, for example using chemical vapour deposition techniques (CVD) or other process steps such as temperature annealing.

As already described in the introductory part of the patent application such metal-carbide substrates are often subjected to a surface treatment, wherein the surface 11 is subjected by a mechanical machining operation in order to obtain a smooth surface 11 that fulfills certain requirements concerning dimensions, smoothness and purity.

A drawback of a mechanical surface treatment such as machining is that in surface 11 multiple, nearly non-visible small microcracks 12 are created, also called subsurface damage.

This subsurface damage adversely affects the semiconductor manufacturing process as all kinds of contaminations present in the microcracks 12 may diffuse out of the microcracks into the clean room environment where the wafers are subjected to subsequent semiconductor layer deposition steps. The contaminations present in the microcracks 12 may therefore adversely affect the quality and yield of the wafers being processed.

According to the invention the method for the treatment of the surface of the metal-carbide substrate 10 comprises the step of etching the surface 11 of said metal-carbide substrate 10 using a reactive gas mixture, thereby creating a carbon surface layer 13 on said metal-carbide substrate 10.

The reactive gas mixture consists of a halogen-containing gas component having a concentration of for example 100%. The reactive gas mixture may also contain a lower halogen-containing gas concentration, as long as the halogen-concentration is high enough to react with the surface 11 of the metal-carbide substrate 10. The halogon-containing gas component can be any chemical from the group of halogens, for example of chlorine (Cl₂) in an Ar-environment, wherein Ar (argon) is used as a carrier gas. Also hydrogen (H₂) can be used as a carrier gas.

Due to the exposure of the subsurface damaged surface 11 of the metal-carbide 10 with the reactive halogen-containing gas mixture, the halogen-containing gas (pure halogen or a halogen-mixture) reacts with the metal-carbide according to the following reaction (1):

SiC + 2 Cl₂ ⇒ SiCl₄ + C (1)

In this example chlorine gas (Cl₂) is used as the reactive halogen-containing component of the reactive gas mixture for the treatment of a silicon-carbide (SiC) substrate 10, but also other halogens or halogen-containing gasses or as-mixtures can be used (such as F₂, Br₂ and I₂).

In another embodiment the reactive gas mixture may contain HCl, which reacts with the metal-carbide (here SiC) according to the following reaction (2):

SiC + 4HCl ⇒ SiCl₄ + C + 2H₂ (2)

According to the reaction between the reactive halogen-containing gas mixture with the metal-carbide surface 11 a carbon layer 13 is formed, the depth d' being dependent from the time interval during which the etching step is performed. The depth d' (or the transition layer 14 between the carbon layer 13 and the metal-carbide substrate 10) needs to be significantly large (deep) in order to cover all microcracks 12 (subsurface damage) being present in the surface 11 of the metal-carbide substrate 10.

The depth of the transition layer 14 (the thickness d' of the carbon-layer 13) is dependent of the etching time and/or the etching conditions (temperature, pressure and halogen-concentrations).

Preferably the working temperature of the etching step lies between 1000 °C till 1200 °C, wherein the flow rate of the reactive gas mixture of chlorine Cl₂ lies between 0.5 - 5 liters per minute. The working pressure may lie between 100 mbar till the ambient pressure.

When the etching step is performed in a halogen environment all kinds of contaminations present on the surface 11 or in the microcracks 12 of the metal-carbide substrate 10 are removed.

In a subsequent method step according to the invention the carbon surface layer 13 being created on said metal-carbide substrate 10 is removed, for example using an oxidation treatment technique. According to another embodiment of said latter method step the carbon surface layer can be removed by means of a hydrogenation or hydrothermical treatment technique.

Also mechanical removal steps can be performed such as blasting or polishing as long as the new metal-carbide layer 14 remains undamaged in order to avoid the same problems as encountered before the etching step of the method according to the invention is being performed.

The removal step of the carbon surface layer 13 may take place at working temperatures between 100 °C till 4000 °C under pressure conditions which may be vacuum till 4000 bar.

As a result of the latter removal step of the carbon surface layer 13 a metal-carbide substrate 10' with a smaller thickness d is obtained with a smooth surface 14 that fulfills the highest requirements as regards to smoothness, and said substrate 10'also exhibits a much higher degree of purity. Due to the absence of any subsurface damage no contaminations can adhere or are present on the surface 14 nor any generation and emission of particles can during the semiconductor manufacturing processes can occur due to the absence of micro cracks in which such particles can be present.

## Claims

1. Method for the treatment of a surface (11) of a metal-carbide substrate (10), said metal-carbide substrate being used in semiconductor manufacturing processes, said method comprising the steps of
selective etching the surface (11) of said metal-carbide substrate (10) using a reactive gas mixture thereby creating a carbon surface layer (13) on said metal-carbide substrate, and
removing said carbon surface layer (13) being created on said metal-carbide substrate (10).

2. The method according to claim 1, wherein the step of removing said carbon surface layer is performed by means of an oxidation treatment technique.

3. The method according to claim 1, wherein the step of removing said carbon surface layer is performed by means of a hydrogenation treatment technique.

4. The method according to claim 1, wherein the step of removing said carbon surface layer is performed by means of a hydrothermical treatment technique.

5. The method according to any one of the preceding claims, wherein the reactive gas mixture being used during the step of etching the surface of said metal-carbide substrate is a halogen-containing gas mixture.

6. The method according to claim 5, wherein the halogen-containing gas concentration of said reactive gas mixture is 100 %.

7. The method according to claim 5, wherein the halogen-containing gas is Cl₂ in an Ar-environment.

8. The method according to claim 5, wherein the reactive gas mixture also contains hydrogen (H₂).

9. The method according to any one of the preceding claims, wherein the flow rate of said reactive gas mixture is 0,5 - 5 litres per minute.

10. The method according to any one of the preceding claims, wherein the working pressure of said reactive gas mixture lies between 100 mbar and the ambient pressure.

11. The method according to any one of the preceding claims, wherein the working temperature of said reactive gas mixture lies between 1000°C and 1200°C.

12. A metal-carbide substrate (10) for use in semiconductor manufacturing processes and obtainable with the method according to claim 1 said metal-carbide substrate comprising a surface (11) having subsurface damage in the form of microcracks (12), wherein on said surface a carbon surface layer (13 is formed by means of an etching technique using a reactive gas mixture, the depth (d') of said carbon surface layer (13) being large enough in order to cover said subsurface damage being present in said surface, which carbon surface (13) layer is subsequently being removed from said metal-carbide substrate.

13. The metal-carbide substrate according to claim 12, wherein said carbon surface layer is removed by means of an oxidation treatment technique.

14. The metal-carbide substrate according to claim 12, wherein said carbon surface layer is removed by means of a hydrogenation treatment technique.

15. The metal-carbide substrate according to claim 12, wherein said carbon surface layer is removed by means of a hydrothermical treatment technique.

16. The metal-carbide substrate according to any one of the claim 12-15, wherein during said etching technique said metal-carbide substrate surface (11) is subjected to a reactive gas mixture containing a halogen-containing gas mixture.

17. The metal-carbide substrate according to claim 16 wherein the halogen-containing gas concentration of said reactive gas mixture is 100 %.

18. The metal-carbide substrate according to claim 16 or 17, wherein the halogen-containing gas is Cl₂ in an Ar-environment.

19. The metal-carbide substrate according to claim 16, 17 or 18, wherein the reactive gas mixture also contains hydrogen (H₂).

20. The metal-carbide substrate according to any one of the claims 12-19, wherein the flow rate of said reactive gas mixture is 0,5 - 5 litres per minute.

21. The metal-carbide substrate according to any one of the claims 12-19, wherein said metal-carbide substrate surface (11) is subjected to a working pressure of said reactive gas mixture between 100 mbar and the ambient pressure.

22. The metal-carbide substrate according to any one of the claims 12-19, wherein said metal-carbide substrate surface (11) is subjected to a working temperature of said reactive gas mixture between 1000 °C and 1200 °C.

## Patentansprüche

1. Verfahren zur Behandlung einer Oberfläche (11) eines Metallcarbid-Substrats (10), wobei das Metallcarbid-Substrat bei Halbleiterherstellungsverfahren verwendet wird, wobei das Verfahren die Schritte umfasst, bei denen
die Oberfläche (11) des Metallcarbid-Substrats (10) unter Verwendung eines reaktionsfähigen Gasgemisches selektiv geätzt wird, wodurch eine Kohlenstoffoberflächenschicht (13) auf dem Metallcarbid-Substrat geschaffen wird, und
die auf dem Metallcarbid-Substrat (10) geschaffene Kohlenstoffoberflächenschicht (13) entfernt wird.

2. Verfahren nach Anspruch 1, bei dem der Schritt, bei dem die Kohlenstoffoberflächenschicht entfernt wird, mittels einer Oxidationsbehandlungstechnik durchgeführt wird.

3. Verfahren nach Anspruch 1, bei dem der Schritt, bei dem die Kohlenstoffoberflächenschicht entfernt wird, mittels einer Hydrierungsbehandlungstechnik durchgeführt wird.

4. Verfahren nach Anspruch 1, bei dem der Schritt, bei dem die Kohlenstoffoberflächenschicht entfernt wird, mittels einer hydrothermischen Behandlungstechnik durchgeführt wird.

5. Verfahren nach einem der vorhergehenden Ansprüche, bei dem das reaktionsfähige Gasgemisch, das während des Schrittes verwendet wird, bei dem die Oberfläche des Metallcarbid-Substrats geätzt wird, ein halogenhaltiges Gasgemisch ist.

6. Verfahren nach Anspruch 5, bei dem die halogenhaltige Gaskonzentration des reaktionsfähigen Gasgemisches 100 % beträgt.

7. Verfahren nach Anspruch 5, bei dem das halogenhaltige Gas Cl₂ in einer Ar-Umgebung ist.

8. Verfahren nach Anspruch 5, bei dem das reaktionsfähige Gasgemisch ferner Wasserstoff (H₂) enthält.

9. Verfahren nach einem der vorhergehenden Ansprüche, bei dem der Durchsatz des reaktionsfähigen Gasgemisches 0,5 bis 5 Liter pro Minute beträgt.

10. Verfahren nach einem der vorhergehenden Ansprüche, bei dem der Betriebsdruck des reaktionsfähigen Gasgemisches zwischen 100 mbar und dem Umgebungsdruck liegt.

11. Verfahren nach einem der vorhergehenden Ansprüche, bei dem die Betriebstemperatur des reaktionsfähigen Gasgemisches zwischen 1000°C und 1200°C liegt.

12. Metallcarbid-Substrat (10) zur Verwendung bei Halbleiterherstellungsverfahren, das mit dem Verfahren nach Anspruch 1 erhalten werden kann, wobei das Metallcarbid-Substrat eine Oberfläche (11) umfasst, die Schäden in Form von Mikrorissen (12) unter der Oberfläche aufweist, und bei dem mittels einer Ätztechnik unter Verwendung eines reaktionsfähigen Gasgemisches eine Kohlenstoffoberflächenschicht (13) auf der Oberfläche gebildet ist, wobei die Tiefe (d') der Kohlenstoffoberflächenschicht (13) ausreichend groß ist, um die in der Oberfläche vorliegenden Schäden unter der Oberfläche abzudecken, wobei die Kohlenstoffoberflächenschicht (13) anschließend von dem Metallcarbid-Substrat entfernt wird.

13. Metallcarbid-Substrat nach Anspruch 12, bei dem die Kohlenstoffoberflächenschicht mittels einer Oxidationsbehandlungstechnik entfernt wird.

14. Metallcarbid-Substrat nach Anspruch 12, bei dem die Kohlenstoffoberflächenschicht mittels einer Hydrierungsbehandlungstechnik entfernt wird.

15. Metallcarbid-Substrat nach Anspruch 12, bei dem die Kohlenstoffoberflächenschicht mittels einer hydrothermischen Behandlungstechnik entfernt wird.

16. Metallcarbid-Substrat nach einem der Ansprüche 12 bis 15, bei dem die Metallcarbid-Substratoberfläche (11) während der Ätztechnik einem reaktionsfähigen Gasgemisch ausgesetzt ist, das ein halogenhaltiges Gasgemisch enthält.

17. Metallcarbid-Substrat nach Anspruch 16, bei dem die halogenhaltige Gaskonzentration des reaktionsfähigen Gasgemisches 100 % beträgt.

18. Metallcarbid-Substrat nach Anspruch 16 oder 17, bei dem das halogenhaltige Gas Cl₂ in einer Ar-Umgebung ist.

19. Metallcarbid-Substrat nach Anspruch 16, 17 oder 18, bei dem das reaktionsfähige Gasgemisch ferner Wasserstoff (H₂) enthält.

20. Metallcarbid-Substrat nach einem der Ansprüche 12 bis 19, bei dem der Durchsatz des reaktionsfähigen Gasgemisches 0,5 bis 5 Liter pro Minute beträgt.

21. Metallcarbid-Substrat nach einem der Ansprüche 12 bis 19, bei dem die Metallcarbid-Substratoberfläche (11) einem Betriebsdruck des reaktionsfähigen Gasgemisches zwischen 100 mbar und dem Umgebungsdruck ausgesetzt ist.

22. Metallcarbid-Substrat nach einem der Ansprüche 12 bis 19, bei dem die Metallcarbid-Substratoberfläche (11) einer Betriebstemperatur des reaktionsfähigen Gasgemisches zwischen 1000°C und 1200°C ausgesetzt ist.

## Revendications

1. Procédé pour le traitement d'une surface (11) d'un substrat en carbure métallique (10), ledit substrat en carbure métallique étant utilisé dans des procédés de fabrication de semi-conducteurs, ledit procédé comprenant les étapes de
attaque sélective de la surface (11) dudit substrat en carbure métallique (10) au moyen d'un mélange gazeux réactif pour créer une couche superficielle de carbone (13) sur ledit substrat en carbure métallique, et
retrait de ladite couche superficielle de carbone (13) créée sur ledit substrat en carbure métallique (10).

2. Procédé selon la revendication 1 où l'étape de retrait de ladite couche superficielle de carbone est réalisée par une technique de traitement d'oxydation.

3. Procédé selon la revendication 1 où l'étape de retrait de ladite couche superficielle de carbone est réalisée par une technique de traitement d'hydrogénation.

4. Procédé selon la revendication 1 où l'étape de retrait de ladite couche superficielle de carbone est réalisée par une technique de traitement hydrothermique.

5. Procédé selon l'une quelconque des revendications précédentes où le mélange gazeux réactif utilisé pendant l'étape d'attaque de la surface dudit substrat en carbure métallique est un mélange gazeux contenant un ou des halogènes.

6. Procédé selon la revendication 5 où la concentration en gaz contenant un ou des halogènes dudit mélange gazeux réactif est 100 %.

7. Procédé selon la revendication 5 où le gaz contenant un ou des halogènes est Cl₂ dans un environnement de Ar.

8. Procédé selon la revendication 5 où le mélange gazeux réactif contient aussi de l'hydrogène (H₂).

9. Procédé selon l'une quelconque des revendications précédentes où le débit dudit mélange gazeux réactif est 0,5-5 I/min.

10. Procédé selon l'une quelconque des revendications précédentes où la pression opératoire dudit mélange gazeux réactif est située entre 100 mbar et la pression ambiante.

11. Procédé selon l'une quelconque des revendications précédentes où la température opératoire dudit mélange gazeux réactif est située entre 1 000°C et 1 200°C.

12. Substrat en carbure métallique (10) destiné à être utilisé dans des procédés de fabrication de semi-conducteurs et pouvant être obtenu avec le procédé selon la revendication 1, ledit substrat en carbure métallique comprenant une surface (11) ayant une détérioration sous la surface sous forme de microfissures (12), où sur ladite surface est formée une couche superficielle de carbone (13) par une technique d'attaque utilisant un mélange gazeux réactif, la profondeur (d') de ladite couche superficielle de carbone (13) étant suffisante pour couvrir ladite détérioration sous la surface présente dans ladite surface, laquelle couche superficielle de carbone (13) est ensuite retirée dudit substrat en carbure métallique.

13. Substrat en carbure métallique selon la revendication 12 où ladite couche superficielle de carbone est retirée par une technique de traitement d'oxydation.

14. Substrat en carbure métallique selon la revendication 12 où ladite couche superficielle de carbone est retirée par une technique de traitement d'hydrogénation.

15. Substrat en carbure métallique selon la revendication 12 où ladite couche superficielle de carbone est retirée par une technique de traitement hydrothermique.

16. Substrat en carbure métallique selon l'une quelconque des revendications 12-15 où, pendant ladite technique d'attaque, ladite surface (11) du substrat en carbure métallique est soumise à un mélange gazeux réactif contenant un mélange gazeux contenant un ou des halogènes.

17. Substrat en carbure métallique selon la revendication 16 où la concentration en gaz contenant un ou des halogènes dudit mélange gazeux réactif est 100 %.

18. Substrat en carbure métallique selon la revendication 16 ou 17 où le gaz contenant un ou des halogènes est Cl₂ dans un environnement de Ar.

19. Substrat en carbure métallique selon la revendication 16, 17 ou 18 où le mélange gazeux réactif contient aussi de l'hydrogène (H₂).

20. Substrat en carbure métallique selon l'une quelconque des revendications 12-19 où le débit dudit mélange gazeux réactif est 0,5-5 litres par minute.

21. Substrat en carbure métallique selon l'une quelconque des revendications 12-19 où ladite surface (11) du substrat en carbure métallique est soumise à une pression opératoire dudit mélange gazeux réactif entre 100 mbar et la pression ambiante.

22. Substrat en carbure métallique selon l'une quelconque des revendications 12-19 où ladite surface (11) du substrat en carbure métallique est soumise à une température opératoire dudit mélange gazeux réactif entre 1 000°C et 1 200°C.
